(19) Europäisches Patentamt
European Patent Office
Office européen des brevets

(11) Publication number: **0 421 337 A1**

(12) # EUROPEAN PATENT APPLICATION

(21) Application number: **90118852.4**

(22) Date of filing: **02.10.90**

(51) Int. Cl.$^5$: **C08L 63/02**, C08L 71/12, B32B 15/08, B32B 27/04, H05K 1/00, //(C08L63/02,71:12), (C08L71/12,63:02)

(30) Priority: **31.08.90 US 575925**
**06.10.89 US 418003**

(43) Date of publication of application:
**10.04.91 Bulletin 91/15**

(84) Designated Contracting States:
**DE ES FR GB IT SE**

(71) Applicant: **GENERAL ELECTRIC COMPANY**
**1 River Road**
**Schenectady New York 12305(US)**

(72) Inventor: **Kubisen, Steven Joseph, Jr.**
**879 Severn Drive**
**Coshocton, Ohio 43812(US)**
Inventor: **Tracy, James Estel**
**7601 Cooks Hill Road Southeast**
**Glenford, Ohio 43739(US)**
Inventor: **Tiburcio, Astrophel Castillo**
**40-E South Westmoor Avenue**
**Newark, Ohio 43055(US)**
Inventor: **Chu, Edward Fuhua**
**1262 Berwyn Lane**
**Newark, Ohio 43055(US)**

(74) Representative: **Catherine, Alain**
**General Electric France Service de Propriété Industrielle 18 Rue Horace Vernet**
**F-92136 Issy-Les-Moulineaux Cedex(FR)**

(54) **Polyphenylene oxide/hybrid epoxy resin system for electrical laminates.**

(57) Disclosed are curable compositions based on a combination of polyphenylene ether, an upstaged epoxy resin combination, a multifunctional epoxy resin, and suitable curing agents. The upstaged epoxy resin combination comprises a low molecular weight brominated upstaged epoxy resin and a monomeric brominated epoxy resin. The composition may be used in the preparation of laminates useful as printed circuit boards.

EP 0 421 337 A1

# POLYPHENYLENE OXIDE/HYBRID EPOXY RESIN SYSTEM FOR ELECTRICAL LAMINATES

## Cross-Reference to Related Applications

This application is a continuation-in-part of application Serial No. 07/418,003, filed October 6, 1989.

## Background of the Invention

The present invention relates to resinous compositions useful as dielectrics and more particularly to polyphenylene ether-polyepoxide compositions suitable for fabrication into printed circuit boards.

A number of polyphenylene ether-polyepoxide compositions having favorable dielectric properties, and supposedly being useful in circuit board manufacture, are known. However, for the most part these have not attained wide commercial use because of deficiencies in one or more properties. Thus, while the polyphenylene ethers are excellent dielectrics and the properties of combinations thereof with polyepoxides are favorable in this respect, they lack solvent resistance which is required in order for the circuit board to survive cleaning. Other deficiencies are found in areas such as flammability, solderability, and resistance to high temperatures. Moreover, times required for curing such compositions are typically too long for effective manufacture of circuit boards in large volume.

In addition to excellent dielectric properties, resinous compositions to be used for printed circiut board manufacture should be highly flame-retardant. A V-1 rating, as determined by Underwriters Laboratories test procedure UL-94, is universally required with V-0 usually being necessary. The V-0 rating requires a flame-out time (FOT) of not more than 10 seconds in any trial and a cumulative FOT of not more than 50 seconds for five samples. As a practical matter, a maximum cumulative FOT of 35 seconds often is mandated by purchasers.

The fabricated board should not lose substantial weight and its surface should not be appreciably marred by contact with methylene chloride, a solvent commonly used for cleaning. Since conductive connections with the printed circuit typically are made by soldering, the board must be solder-resistant as evidenced by the lowest possible percent increase in thickness (Z-axis expansion) when exposed to liquid solder at 288° C. In addition to all these properties of the cured material, a relatively short curing time is highly desirable.

In Japanese Kokai 58/69052, combinations of polyphenylene ethers with various types of polyepoxides are disclosed. The latter include epoxy novolak resins and polyglycidyl ethers of such compounds as bisphenol A and 2,2-bis(3,5-dibromo-4-hydroxyphenyl)propane, commonly referred to as tetrabromobisphenol A. Curing of these compositions is achieved by contact with various known curing agents, including amines. The cured compositions, however, have been found to be seriously deficient in solvent resistance and, in certain cases, in solderability.

Copending, commonly-assigned application Serial No. 219,106, filed July 14, 1988, discloses curable polyphenylene ether-polyepoxide compositions incorporating partially cured ("upstaged") products prepared from halogen-free bisphenol polyglycidyl ethers, halogen-free epoxidized novolaks, and bisphenols containing bromine as aryl substituents. Cured materials prepared therefrom have utility for laminate and circuit board production. These compositions generally have the aforementioned desirable properties. However, there is room for improvement in the areas of flow rate and degree of fiber saturation. Moreover, fluctuations in degree of solderability sometimes are observed. This latter condition appears to be the result, at least in part, of the necessary incorporation of antimony pentoxide in the composition as a flame retardancy synergist, more particularly in combination with a dispersing agent as described hereinafter.

Copending, commonly-assigned application Serial No. 288,214, filed December 22, 1988, discloses curable polyphenylene ether-polyepoxide compositions where the polyepoxide composition is based on a monomeric bisphenol polyglycidyl ether having an average of at most one aliphatic hydroxyl group per molecule and containing about 10%-30% bromine as aryl substituents. This monomeric system exhibits improved processability in the treating operation, but does not yet have cure speed as fast as some manufacturers desire. The high content of brominated monomeric polyepoxide contributes to the cost of such composition also. Finally, Z-direction thermal expansion coefficients of laminates based on this monomeric system may be higher than is acceptable in some uses of laminates made therewith. Accordingly, room for improvement with respect to these factors exists.

In addition, curable compositions suitable for bonding sheet fabrication are needed. Bonding sheets are employed when a multi-layer structure is desired, involving etching of numerous printed circuits followed by

their lamination into a single unit. For this purpose, a fiber-reinforced resinous bonding sheet is employed to separate the etched copper circuitry on two successive circuit boards, with the desired connections being made through the bonding sheet.

The bonding sheet composition must generally have a substantially higher flow rate when melted under low pressure than a composition employed in circuit board manufacture. It must also have a relatively high resin loading, since the resin must completely fill the voids created during the etching of circuits in the printed circuit boards. Extended cure time also is necessary, in order that the required flow may be achieved before curing is initiated. The formulation must be compatible with the base material in the circuit board. Finally, flexibility is preferred in a bonding sheet, unlike laminates for circuit boards in which stiffness is required.

## Broad Statement of the Invention

The present invention is directed to a curable composition containing at least about 5% chemically combined bromine. When used to impregnate suitable fibrous reinforcing materials such as glass cloth fiber, such composition furnishes workable prepregs. For present purposes, "prepreg" means a curable article comprising a substrate impregnated with an uncured or partially cured resinous material. The curable composition of the present invention is readily soluble in organic solvents, facilitating impregnation. The cured materials prepared therefrom are solder resistant, solvent resistant, can be made flame retardant, and have excellent dielectric properties and dimensional stability at high temperature. Therefore, the curable composition when cured excels in the manufacture of laminates and bonding sheets for printed circuit boards.

The curable composition of the present invention comprises:

(a) between about 25% and 50% of at least one polyphenylene ether or polyphenylene oxide (PPO);

(b) between about 40% and 60% of a combination comprising

(i) between about 35% and 45% of a brominated upstaged polyepoxide composition comprising the reaction product of a halogen-free diglycidyl ether of a bisphenol and a bisphenol containing bromine as aryl substituents; and

(ii) between about 55% and 65% of a polyepoxide composition comprising at least one bisphenol polyglycidyl ether having an average of at most one aliphatic hydroxyl group per molecule and containing between about 10% and 60% bromine as aryl substituents;

(c) up to about 25% of a halogen-free epoxidized novolak;

(d) a catalytically-effective amount of a catalyst; and

(e) an inert solvent. The foregoing percentages all are weight percentages and the percentages of (a), (b), and (c) exclude (d) and (e). Prepregs made with the inventive curable composition form another aspect of the present invention.

Advantages of the present invention include a PPO/epoxy resin system with good processability in the treating operation, higher prepreg resin flow, and lower laminate Z-direction thermal expansion coefficients. Further advantages include the retention of methylene chloride resistance, molten solder resistance, and UL-94 V-O flammability characteristics. These and other advantages will be apparent readily to those skilled in the art based upon the disclosure set forth herein.

## Detailed Description of the Invention

The present invention is based upon the discovery that certain defined blends of polyphenylene ether (PPO) and polyepoxides provide curable compositions ideally suited for use in fabricating printed circuit boards. The polyepoxide portion is a combination of an upstaged (pre-reacted or partially cured) polyepoxide composition and a monomeric polyepoxide. Fortuitously, drawbacks related to use of only an upstaged polyepoxide system or only a monomeric brominated polyepoxide system, as proposed in the art, are overcome by use of the polyepoxide composition combination disclosed herein.

Referring initially to the polyphenylene ethers useful in formulating the inventive curable composition, polyphenylene ethers comprise a plurality of structural units having the formula

(I)

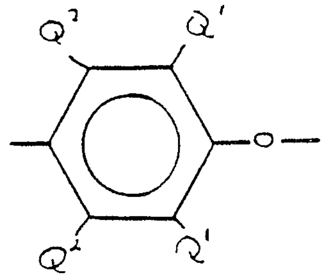

In each of said units independently, each $Q^1$ is independently halogen, primary or secondary lower alkyl (i.e., alkyl containing up to 7 carbon atoms), phenyl, haloalkyl, aminoalkyl, hydroxycarbonoxy, or halohydrocarbonoxy wherein at least two carbon atoms separate the halogen and oxygen atoms; and each $Q^2$ independently is hydrogen, halogen, primary or secondary lower alkyl, phenyl, haloalkyl, hydrocarbonoxy or halohydrocarbonoxy as defined for $Q^1$. Examples of suitable primary lower alkyl groups are methyl, ethyl, n-propyl, n-butyl, isobutyl-, n-amyl, isoamyl, 2-methylbutyl, n-hexyl, 2,3-dimethylbutyl, 2-, 3- or 4-methylpentyl and the corresponding heptyl groups. Examples of secondary lower alkyl groups are isopropyl, sec-butyl and 3-pentyl. Preferably, any alkyl radicals are straight chain rather than branched. Most often, each $Q^1$ is alkyl or phenyl, especially $C_{1-4}$ alkyl, and each $Q^2$ is hydrogen.

Both homopolymer and copolymer polyphenylene ethers are included. Suitable homopolymers are those containing, for example, 2,6-dimethyl-1, 4-phenylene ether units. Suitable copolymers include random copolymers containing such units in combination with (for example) 2,3,6-trimethyl-1, 4-phenylene ether units. Many suitable random copolymers, as well as homopolymers, are disclosed in the patent literature.

Also included are polyphenylene ethers containing moieties which modify properties such as molecular weight, melt viscosity, and/or impact strength. Such polymers are described in the patent literature and may be prepared by grafting onto the polyphenylene ether in known manner such non-hydroxy-containing vinyl monomers as acrylonitrile and vinylaromatic compounds (e.g., styrene), or such non-hydroxy-containing polymers as polystyrenes and elastomers. The product typically contains both grafted and ungrafted moieties. Other suitable polymers are the coupled polyphenylene ethers in which the coupling agent is reacted in known manner with the hydroxy groups of two polyphenylene ether chains to produce a higher molecular weight polymer containing the reaction product of the hydroxy groups and the coupling agent. Illustrative coupling agents are low molecular weight polycarbonates, quinones, heterocycles, and formals.

For the purposes of this invention, the polyphenylene ether has a number average molecular weight within the range of about 3,000-40,000, preferably at least about 12,000 and most preferably at least about 15,000, and a weight average molecular weight within the range of about 20,000-80,000, as determined by gel permeation chromatography. Its intrinsic viscosity is most often in the range of about 0.15-0.6 dl./g., as measured in chloroform at 25° C.

The polyphenylene ethers are typically prepared by the known oxidative coupling of at least one corresponding monohydroxyaromatic compound. Particularly useful and readily available monohydroxyaromatic compounds are 2,6-xylenol (wherein each $Q^1$ is methyl and each $Q^2$ is hydrogen), whereupon the polymer may be characterized as a poly(2,6-dimethyl-1, 4-phenylene ether), and 2,3,6-trimethylphenol (wherein each $Q^1$ and one $Q^2$ are methyl and the other $Q^2$ is hydrogen).

Particularly useful polyphenylene ethers for the purposes of this invention are those which comprise molecules having aminoalkyl-substituted end groups, as described in numerous patents and publications. Such molecules frequently constitute a substantial proportion of the polyphenylene ether, typically as much as about 90% by weight. Polymers of this type may be obtained by incorporating an appropriate primary or secondary monoamine as one of the constituents of the oxidative coupling reaction mixture.

It will be apparent to those skilled in the art from the foregoing description that the polyphenylene ethers contemplated for use in the present invention include all those presently known, irrespective of variations in structural units or ancillary chemical features.

The brominated upstaged polyepoxide composition of this invention, component (i), is prepared by the reaction of two or three reagents of which one is at least a halogen-free bisphenol polyglycidyl ether. The most common compounds of this type are prepared by the reaction of bisphenols with epichlorohydrin. (By "bisphenol" as used herein is meant a compound containing two hydroxyphenyl groups attached to an aliphatic or cycloaliphatic moiety, which may also contain aromatic substituents.) Said compounds may be represented by the formula:

(II) 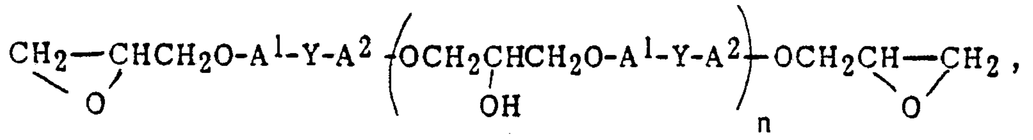

wherein n has an average value up to 1, each of $A^1$ and $A^2$ is a monocyclic divalent aromatic radical and Y is a bridging radical in which one or two atoms separate $A^1$ from $A^2$. The O-$A^1$ and $A^2$-O bonds in formula I are usually in the meta or para positions of $A^1$ and $A^2$ in relation to Y.

In formula II, the $A^1$ and $A^2$ values may be unsubstituted phenylene or substituted derivatives thereof, illustrative substituents (one or more) being alkyl, nitro, alkoxy and the like. Unsubstituted phenylene radicals are preferred. Each of $A^1$ and $A^2$ may, for example, be o- or m-phenylene and the other p-phenylene, but both preferably are p-phenylene.

The bridging radical, Y, is one in which one or two atoms, preferably one, separate $A^1$ from $A^2$. It is most often a hydrocarbon radical and particularly a saturated radical such as methylene, cyclohexylmethylene, ethylene, isopropylidene, neopentylidene, cyclohexylidene, or cyclopentadecylidene, especially a gem-alkylene (alkylidene) radical and most preferably isopropylidene. Also included, however, are radicals which contain atoms other than carbon and hydrogen; for example, carbonyl, oxy, thio, sulfoxy, and sulfone.

The materials which are preferred are commercially available reaction products of epichlorohydrin and 2,2-bis(4-hydroxyphenyl)propane (bisphenol A), including EPON 825 (n = 0) and EPON 828 (n = about 0.14), available from Shell Chemical Co.

The second reagent is at least one bisphenol containing bromine in the form of substituents of the aromatic rings, usually a brominated derivative of bisphenol A. Its purpose according to the invention is principally to provide flame retardancy. 2,2-Bis(3,5-dibromo-4-hydroxyphenyl)propane is preferred as this reagent because of its availability, relatively low cost and particular suitability for the purposes of the invention.

Component (ii) is a polyepoxide composition comprising at least one bisphenol polyglycidyl ether. It usually comprises a mixture of such ethers, part of the components of said mixture being halogen-free and the balance thereof containing bromine as aryl substituents. The total amount of bromine therein is about 10%-60% by weight.

Compounds of this type are prepared conventionally by the reaction of bisphenols with epichlorohydrin. (By "bisphenol" as used herein is meant a compound containing two hydroxyphenyl groups attached to an aliphatic or cycloaliphatic moiety, such may also contain aromatic substituents.) Said compounds may be represented by the formula:

(III) 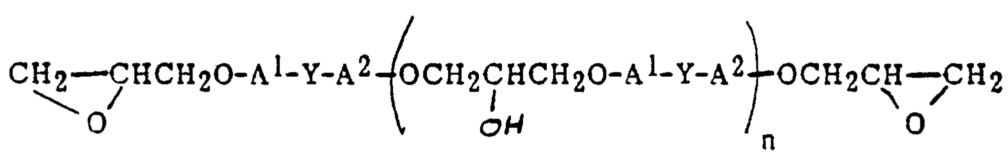

wherein m is 0-4, n has an average value up to 1, each of $A^1$ and $A^2$ is a monocyclic divalent aromatic radical, and Y is a bridging radical in which one or two atoms separate $A^1$ from $A^2$. The O-$A^1$ and $A^2$-O bonds in formula III are usually in the meta or para positions of $A^1$ and $A^2$ in relation to Y.

In formula III, the $A^1$ and $A^2$ values may be unsubstituted phenylene or substituted derivatives thereof, illustrative substituents (one or more) being alkyl, nitro, alkoxy and the like. Unsubstituted phenylene radicals are preferred. Each of $A^1$ and $A^2$ may, for example, be o- or m-phenylene and the other p-phenylene, but both are preferably p-phenylene.

The bridging radical, Y , is one in which one or two atoms, preferably one, separate $A^1$ from $A^2$. It is most often a hydrocarbon radical and particularly a saturated radical such as methylene, cyclohexylmethylene, ethylene, isopropylidene, neopentylidene, cyclohexylidene, or cyclopentadecylidene, especially a gem-alkylene (alkylidene) radical and most preferably isopropylidene. Also included, however, are radicals which contain atoms other than carbon and hydrogen; for example, carbonyl, oxy, thio, sulfoxy, and sulfone.

In most instances, component ii comprises at least two bisphenol polyglycidyl ethers, one being brominated (m is 1-4, preferably 2) and the other bromine-free (m is 0). The proportions thereof are based on the required bromine content for component ii of about 10%-60%. The preferred materials are commercially available reaction products of epichlorohydrin and 2,2-bis(4-hydroxyphenyl)propane

(bisphenol A), including EPON 825 (n = 0) and EPON 828 (n = about 0.14), available from Shell Chemical Co., and simliar products prepared from epichlorohydrin and tetrabromobisphenol A. The principal purpose of the brominated compounds is to provide flame retardancy.

Component ii preferably is blended with component ifor formulating the polyepoxide portion (b) of the curable composition. Alternatively, however, component ii can be incorporated with the halogen-free diglycidyl ether of a bisphenol and the brominated bisphenol components, and the three components reacted to produce a low molecular weight, high bromine content moeity.

The reaction mixture comprising the reagents forming component (i) and optionally component (ii) is heated, most often at a temperature in the range of about 120°-225°C, preferably about 140°-200°C, and most preferably about 160°-190°C, in the presence of a catalytic amount of at least one basic reagent. Said mixture preferably consists essentially of said reagents; that is, they are the only ones contributing to the novel and essential properties thereof.

The triarylphosphines, especially triphenylphosphine, are the preferred basic reagents by reason of their effectiveness at low levels, low tendency to cause side reaction, and neutrality when they remain present after the reaction is complete. The proportion of catalyst is typically about 0.1%-0.5% by weight. The reaction is preferably conducted in an inert atmosphere such as nitrogen, especially when a triarylphosphine is employed as the catalyst. An inert organic solvent having a boiling point no higher than about 125°C, usually an aromatic hydrocarbon such as toluene, may be employed but usually provides no advantage at this point.

The structure of the resinous composition thus obtained is not fully known. It is believed to be an "upstaged" (i.e., partially cured) composition derived from the compounds of formula III, in which the brominated moieties form part of the molecular structure.

Optional reagent (c) is at least one halogen-free epoxidized novolak. Suitable novolaks for use as precursors therefor are known in the art and typically are prepared by the reaction of formaldehyde with a hydroxyaromatic compound such as phenol (which is often preferred), cresol, or t-butylphenol. The novolak then undergoes reaction with an epoxy reagent such as epichlorohydrin to produce the resin useful as reagent (c).

Various epoxidized novolaks are commercially available, and any of them may be used according to the invention. It is usually strongly preferred that the epoxidized novolak contains substantially no free phenolic hydrogen atoms.

Component (d) is any catalyst effective as a curing agent for epoxy resins, e.g. imidazoles and arylene polyamines. Particularly useful imidazoles are imidazole, 1-methylimidazole, 1,2-dimethylimidazole, 2-methylimidazole, 2-heptadecylimidazole, 2-ethyl-4-methylimidazole, 2-undecylimidazole, and 1-(2-cyanoethyl)-2-phenylimidazole. Representative useful arylene polyamines include, for example, diethyltoluenediamine, tris(dimethylaminomethyl)phenol, and 3-phenyl-1,1-dimethyl urea. Commercially available imidazole-arylene polyamine mixtures can be used; the especially preferred mixtures contain arylene polyamines with a high degree of alkyl substitution on the aromatic ring, typically at least three such substituents. The diethylmethyl-substituted m- and p-phenylenediamines are generally the most preferred polyamines.

Unexpectedly, silane coupling agents added to improve wetting out of the fabric reinforcement displayed effective catalytic behavior in the curable formulation. Silanes evaluated include 3-(2-aminoethyl)-aminopropyl trimethoxysilane, gamma-aminopropyl triethoxysilane, and glycidoxypropyl trimethoxysilane. The amine-containing silanes proved more effective. Silanes can be used as co-catalysts or can be the primary catalyst, as the data reveals.

The amount of component (d) is a catalytically effective amount to achieve curing, preferably rapidly after solvent removal. Most often, it is at least 4.5 and preferably at least 10 milliequivalents of basic nitrogen per 100 parts of total curable composition, including any basic nitrogen present in the polyphenylene ether (mostly as aminoalkyl-substituted end groups). Thus, when a polyphenylene ether essentially free from basic nitrogen is employed the proportion of component (d) must be increased. (For the purpose of this invention, the equivalent weight of an imidazole is its molecular weight and that of a diamine is half its molecular weight.)

Co-catalysts and activators desirably also are used for achieving advantageous cure rates of the inventive curable composition. Salts of diketones in which one carbon atom separates the carbonyl groups, especially acetylacetonates, and salts of fatty acids, especially stearates and octoates, are examples of suitable forms of zinc, magnesium, or aluminum for this purpose. Specific examples include zinc acetylacetonate, zinc stearate, magnesium stearate, aluminum acetyl acetonate, zinc octoate, zinc neodecanoate, and zinc naphthenate. In general, the fatty acid salts are preferred when component (d) contains alkylene polyam ides, and diketone salts are preferred when component (d) is entirely imidazole.

Additional secondary catalysts include, for example, maleic anhydride and $BF_3$-ethylamine complex.

Under certain conditions, acetylacetonates such as zinc acetylacetonate can form hydrates which readily lose acetylacetone and become insoluble in the organic systems used for laminate preparation. Therefore, it may be necessary to take steps to maintain the zinc or aluminum in stable dispersion. One means for doing this is to subject the composition to continuous agitation; however, this is generally not practical. A better method is to form an alcholate of the acetylacetonate, as by reaction with methanol. The alcoholate loses alcohol rather than acetylacetone under similar conditions, remaining in solution or homogeneous suspension.

Another method for maximizing homogeneity is to employ a fatty acid salt. Still another method is to employ a titanium compound as a compatibilizer, as disclosed hereinafter.

Co-catalysts are employed in a cocatalytically effective amount, and generally also serves to improve solvent resistance and flame retardancy. About 0.1%-1.5% of zinc, magnesium, or aluminum, based on total curable composition, is usually present.

Various other materials may be employed in the curable compositions of this invention; the presence of certain of them usually is preferred. One of these is (c) at least one epoxidized novolak, most often halogen-free. It is usually employed in the amount of about 5-10 parts by weight per 100 parts of total components (a) and (b).

Among the other materials which may be present are inert, particulate fillers such as talc, clay, mica, silica, alumina, and calcium carbonate. In addition, the bromine content of the curable composition may be supplied in part by materials such as alkyl tetrabromophthalates and/or epichlorohydrin reaction products with mixtures of bisphenol A and tetrabromobisphenol A. The alkyl tetrabromophthalates also serve as plasticizers and flow improvers. Fabric wettability enhancers (e.g. wetting agents and coupling agents) and polar liquids such as n-butyl alcohol, methyl ethyl ketone, polysiloxanes, and tetrahydrofuran, may be advantageous under certain conditions. Such materials as antioxidants, thermal and ultraviolet stabilizers, lubricants, antistatic agents, dyes, and pigments may also be present.

An important feature of the invention is the fact that flame retardancy synergists, such as antimony pentoxide, generally are not necessary. However, they may be incorporated when appropriate.

When antimony pentoxide is employed, it must be maintained in stable dispersion. This may be done by agitation and/or combination with a suitable dispersing agent, of which many are known in the art. The proportion of antimony pentoxide is usually up to about 4 parts per 100 parts of components (a)-(d).

One preferred dispersing agent is a polymer which is compatible with the resinous constituents of the curable composition but is substantially non-reactive under the conditions employed, typically a polyester. More powerful dispersing agents, such as amines, may be required when the zinc or aluminum salt is a fatty acid salt, since such salts may otherwise form insoluble complexes with antimony pentoxide.

A material whose presence in minor amount may improve the solvent resistance and compatibility of the curable composition, and is therefore preferred, is at least one aliphatic tris(dialkylphosphato)titanate. Suitable phosphatotitanates are known in the art and commercially available. They may be represented by the formula

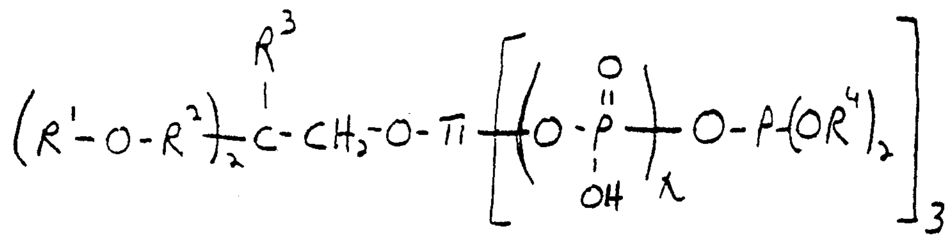

wherein $R^1$ is $C_{2-6}$ primary or secondary alkyl or alkenyl and preferably alkenyl; $R^2$ is $C_{1-3}$ alkylene and preferably methylene; $R^3$ is $C_{1-5}$ primary or secondary alkyl; and x is from 0 to about 3 and is preferably 0 or 1. Most preferably, $R^1$ is alkyl, $R^3$ is ethyl, $R^4$ is octyl, and x is 0. the phosphatotitanate is most often present in the amount of about 0.1-1.0 part by weight per 100 parts of the resinous composition.

The present invention includes all compositions which comprise the above-described constituents, including those containing other unspecified ingredients. However, the compositions which are often preferred consist essentially of components (a)-(d); that is, said components are the only ones which materially affect the basic and novel characteristics of the compositions.

Another aspect of the invention is prepregs comprising a fibrous substrate (woven or non-woven) such as glass, quartz, polyester, polyamide, polypropylene, cellulose, nylon or acrylic fibers, preferably glass,

impregnated with the curable composition and obtained upon removal of the solvent therefrom by evaporation or the like. Such prepregs may be cured by application of heat and pressure. The resulting cured articles are other aspects of the invention.

Typically, 2- to 20-ply laminates are compression molded at temperatures in the range of about 200°-250° C and under pressures on the order of 280-850 psi. Laminates clad with a conductive metal such as copper, useful for printed circuit board production, may be so prepared and cured by art-recognized methods. As previously mentioned, printed circuit board blanks comprising said laminates are characterized by excellent dielectric properties, solderability, flame retardancy, and resistance to high temperature conditions and solvents. The metal cladding then may be conventionally patterned.

The following example shows how the present invention has been practiced, but should not be construed as limiting. In this application, all percentages and parts are by weight, and all units are in the metric system, unless otherwise expressly indicated. Also, all citations referred to herein are expressly incorporated herein by reference.

## IN THE EXAMPLES

The following ingredients were employed in formulating curable compositions in accordance with the present invention:

Polyphenylene ether--a poly(2,6-dimethyl-1,4-phenylene ether) having a number average molecular weight of about 20,000, an intrinsic viscosity in chloroform at 25° C of 0.40 dl./g and a nitrogen content of about 960 ppm.

Component 270-75--reaction product of EPON 828 diglycidyl ether of bisphenol A, (epoxide equivalent weight 185-192, Shell Chemical Co.) and tetrabromobisphenol A (3.5:1.0 molar ratio), reactions initiated at 120° C using triphenylphosphine catalyst, in toluene solvent.

Component 270-188--reaction product of EPON 828 diglycidyl ether of bisphenol A, tetrabromobisphenol A, and DER 542 brominated epoxy monomer (48.8% bromine content, 328 epoxide equivalent weight, Dow Chemical Co.), 1.01:1.0:2.51 molar ratio, reactions initiated at 120° C using triphenylphosphine catalyst.

EPN-1138--an epoxy novolak resin supplied by Ciba-Geigy.

Zinc octoate--THERM-CHEK T-705 brand (80% active zinc octoate in mineral spirits, Ferro Corp.).

Imicure EMI-24--2-ethyl-4-methylimidazole supplied by Air Products Co.

Epolite 2347--mixture of 1,2-dimethylimidazole and isomers of diethyltoluenediamine, average equivalent weight of about 91 (Hexel Corp.).

Ethacure 100--Diethyl toluenediamine (Ethyl Corp.).

Ken-React Lica 12--Titanium IV neoalkenalto, tris(dioctyl) phosphato-O (Kenrich Petrochemicals Inc.).

ADP-480--75% antimony pentoxide coated with an amine powder (Nyacol Products, Inc.).

Cabosil M-5 calcined fumed silica, surface area 200 $m^2/g$ Cabot Corp.

A-1100, gamma-aminopropyl triethoxysilane, Union Carbide Corp.

Aerosil 200 fumed silica-Degussa Corp.

Additive 57, polysiloxane wetting agent, Dow Corning Corp.

## EXAMPLE 1

The formulations set forth in Table 1 below were applied to style 7628 woven fiberglass fabric through a conventional impregnation process using a laboratory pilot-scale vertical treater, following standard treating procedures in the electrical laminate art to control key prepreg characteristics including, for example, weight percent resin content, percent flow, and percent volatiles. The prepregs were pressed into 30.48 cm x 38.1 cm (12 in. x 15 in.) double-clad (1 oz copper/$ft^2$) electrical laminates in a standard electrically-heated hydraulic press. Cure speed estimates were based on the rate of development of methylene chloride resistance and solder resistance at 288° C (550° F) for 30 seconds of 15.24 cm x 15.24 cm (6 in. x 6 in.) 8-ply unclad test laminates pressed in the same manner.

TABLE 1

| PPO/HYBRID EPOXY SYSTEMS FORMULATIONS (gms.) | | | | | | | | |
|---|---|---|---|---|---|---|---|---|
| | 108 | 110 | 111 | 113 | 99 | 62 | 63 | 109 |
| Toluene | 5465 | 4061 | 5465 | 5367 | 5301 | 3850 | 3284 | 4284 |
| Methyl Ethyl Ketone | -- | -- | -- | -- | 550 | 500 | 426 | -- |
| PPO (0.40 iv) | 1675 | 1675 | 1675 | 1675 | 1650 | 2850 | 2431 | 1552 |
| Bisphenol A | -- | 67 | -- | -- | -- | -- | -- | -- |
| 70% Benzoyl peroxide | -- | 96 | -- | -- | -- | -- | -- | -- |
| 270-75 (85% in toluene) | 1262 | -- | -- | -- | 1243 | -- | -- | -- |
| 270-75 (75% in toluene) | -- | 1430 | 1430 | 1430 | -- | 1500 | 1280 | -- |
| 270-188 (75% in toluene) | -- | -- | -- | -- | -- | -- | -- | 2503 |
| DER 542 | 1646 | 1646 | 1646 | 1646 | 1408 | -- | -- | -- |
| DER 542 (30% in toluene) | -- | -- | -- | -- | -- | 5000 | 4265 | -- |
| EP-1138 (75% in toluene) | 1097 | 1097 | 1097 | 1097 | 1365 | -- | -- | 845 |
| Zinc octoate | 300 | 300 | 300 | 300 | 330 | 300 | 256 | 261 |
| Epolite 2347 | -- | -- | -- | -- | -- | 37.5 | -- | -- |
| Ethacure 100 | 50 | 50 | -- | -- | 49 | -- | -- | 39 |
| 1-Methylimidazole | 21 | 21 | 42 | 21 | 21 | -- | -- | 17 |
| 1,2-Dimethylimidazole | -- | -- | -- | -- | -- | -- | 11 | -- |
| LICA 12 | -- | -- | -- | -- | 28 | 30 | 26 | -- |
| ADP-480 | -- | -- | -- | -- | 78.6 | -- | -- | -- |

Formulation 108 illustrates preparation of a V-O flammability laminate utilizing only the organically-bound bromine of the epoxy component (ca. 18% bromine based on PPO plus epoxide components) as the flame retardant. Formulations 110, 111, and 113 are variants of Formulation 108. Formulation 110 utilizes "equilibrated PPO" which was prepared by pre-reacting PPO with benzoyl peroxide in the presence of bisphenol A, thereby reducing the molecular size of the PPO chains via a cleavage reaction. The use of equilibrated PPO results in a marked reduction in varnish mix viscosity, thus producing better fabric saturation and higher flow prepreg in the treating operation. Additionally, laminates pressed from these equilibrated PPO prepregs exhibited a single $T_g$ in DMA (Dynamic Mechanical Analysis) curves, in contrast to other PPO/epoxide formulations which show multiple $T_g$s. Formulation 111 omitted the aromatic diamine and doubled the quantity of imidazole. This resulted in increased cure speed, but also gave lower $T_g$ values and reduced the methylene chloride resistance of the prepreg. Formulation 113 omitted the aromatic diamine and kept the quantity of imidazole the same as Formulation 108. This also resulted in lower $T_g$ values and reduced methylene chloride resistance. Formulation 99 illustrates the use of antimony pentoxide to obtain V-O flammability rating on a lower bromine content formulation (ca. 16% bromine). Without the presence of antimony pentoxide, the formulation rated V-1. Formulations 62 and 63 contained no epoxidized novolak component which resulted in low flows and reduced methylene chloride solvent resistance. Formulation 109 utilized an upstaged polyepoxide composition which included the bisphenol polyglycidyl ether component reacted in rather than blended with the upstaged polyepoxide composition.

Typical laminate properties obtained utilizing the formulations set forth above are recorded below.

TABLE 2(A)

PPO/HYBRID EPOXY SYSTEMS

TYPICAL LAMINATE PROPERTIES

| Prepreg | 108-1 | 110-4 | 111-3 | 111-1 | 113-3 |
|---|---|---|---|---|---|
| % Resin Content | 43 | 44 | 46.5 | 43 | 44 |
| % Flow (240° C/600 psi) | 17 | 24 | 18 | 12 | 17 |
| % Volatiles (165°C) | 0.7 | 0.4 | 0.8 | 0.3 | 0.4 |
| Est. Cure Speed at 245°C (development of MC resistance) | 5-6 min. | 3 min. | — | 4-5 min. | 6 min. |

TABLE 2(A) cont'd

| Prepreg | 99-2 | 62-3 | 63-2 | 109-3 |
|---|---|---|---|---|
| % Resin Content | 43 | 42.5 | 42 | 41 |
| % Flow (240° C/600 psi) | 16 | 1.4 (230°/600 psi) | 2(230°/600 psi) | 9 |
| % Volatiles (165°C) | 0.5 | 0.5 | 0.5 | 0.5 |
| Est. Cure Speed at 245°C (development of MC resistance) | 4-6 min. | 4-6 min. | 6-8 min. | 6 min. |

TABLE 2(B)

| Laminate | 108-1 | 110-4 | 111-3 | 111-1 | 113-3 |
|---|---|---|---|---|---|
| Pressing Conditions (°C/psi/min) | 250/500/20 remove hot | 177/200/30 then 250/200/5 remove hot | 250/500/10 remove hot | 250/500/10 remove hot | 250/500/10 remove hot |
| No. of plies | 8 | 8 | 7 | 8 | 8 |
| Thickness (in) | .0594 | .0603 | .0583 | .0613 | .0593 |
| % Z-axis exp. (TMA) | 3.8 | 4.3 | 5.0 | 4.4 | 4.4 |
| Tg (°C) DMA (E") | 168/205 | 18 | 127/145/182 | 131/144/195 | 139/200 |
| Water absorption (%) | — | — | — | — | — |
| Flammability, UL | V-0(31) | V-0(18) | V-0(18) | V-0(29) | V-0(44) |
| D.C., A | 4.2 | — | 3.9 | 4.1 | — |
| D.C., D-24/23 | — | — | — | — | — |
| D.F., A | .010 | — | .012 | .012 | — |
| D.F., D-24/23 | — | — | — | — | — |
| Peel Str., A (lb/in) | 12.8 | — | 12.8 | 11.0 | — |
| Sec. to Blister at 550°F | 300+ | — | 235 (210/210/286) Mottled | 300+ | — |
| % Ash | 60 | — | — | — | — |
| % Loft-Solder dip at 550°F-10 sec | — | — | — | — | — |
| % Loft-Solder dip at 550°F-30 sec | 0.2 | -0.2 | -0.4 | -0.2 | -0.2 |
| % Loft-Solder dip at 550°F-60 sec | 0.0 | 0.0 | -0.2 | 0.0 | -0.2 |
| MC Resistance-5 min dip* | OK | Good (10 min) | OK | OK | MARG |
| MC Absorption (%) | 1.2 | 0.9 | 1.9 | 1.7 | — |

TABLE 2(B) cont'd

| Laminate | 99-2 | 62-3 | 63-2 | 109-3 |
|---|---|---|---|---|
| Pressing Conditions (°C/psi/min) | 250/500/10 remove hot | 240/475/15 cool to 165°C | 240/475/15 cool to 165°C | 250/500/10 remove hot |
| No. of plies | 8 | 8 | 8 | 8 |
| Thickness (in) | .0603 | .0644 | .0648 | .0575 |
| % Z-axis exp. (TMA) | 4.1 | 4.5 | 4.3 | 4.2 |
| Tg (°C) DMA (E") | 152/203 | 131/161/193 | 133/158/195 | 153/164/199 |
| Water absorption (%) | — | .06 | .07 | -- |
| Flammability, UL | V-O(21) | V-O(29) | V-O(40) | V-O(22) |
| D.C., A | — | 3.8 | 3.8 | 4.1 |
| D.C., D-24/23 | — | 3.9 | 3.9 | — |
| D.F., A | — | .009 | .009 | .010 |
| D.F., D-24/23 | — | .011 | .011 | — |
| Peel Str., A (lb/in) | 12.6 | 14.8 | 14.0 | 15.0 |
| Sec. to Blister at 550°F | 300+ -- | 246 (250/232/256) | 236 (255/154/300) | 120 (60/120/150) Mottled- Did not blister |

TABLE 2(B) cont'd

| Laminate | 99-2 | 62-3 | 63-2 | 109-3 |
|---|---|---|---|---|
| % Ash | 60 | — | -- | -- |
| % Expansion-Solder dip at 550°F-10 sec | — | 0.6 | 0.0 | -- |
| % Expansion-Solder dip at 550°F-30 sec | -0.2 | 0.2 | 0.3 | 0.5 |
| % Expansion-Solder dip at 550°F-60 sec | 0.2 | — | -- | blister |
| MC Resistance-5 min dip* | OK | NG-Whitens | NG-Whitens | MARG-OK |
| MC Absorption (%) | 1.0 | 2.1 | 2.1 | 0.91 |

*MC Resistance Ratings: (Appearance)

NG - Not Good

MARG - Not as good as S-6603 (NCR Standard), but possibly acceptable

OK - Equal or somewhat better than S-6603

GOOD - Substantially better than S-6603

The foregoing data establishes the invention.

EXAMPLE 2

Additional formulations were compounded:

Run 209

In an appropriate reaction vessel equipped with efficient stirring and a steam-heated jacket, PPO (312 g) was equilibrated with bisphenol-A (19 g) and 78% benzoyl peroxide (24 g) in toluene (2766 g) and 30% DER-542 brominated epoxy (5487 g) at 95° C for 90 minutes. Additional PPO (1675 g) then was added and the mixture maintained at 90°-95° C for an additional 30 minutes after which heating was discontinued. The stirred mixture then was allowed to cool toward 60° C as Component 270-75 (75% solids in toluene solvent, 1430 g), EPN-1138 epoxy Novolac resin (75% solids in toluene, 681 g), T-705 zinc octoate (300 g), and heptadecylimidazole catalyst (42 g) were added. This mixture was stirred and held at 50°-60° C for a minimum of 15 minutes, then applied to style 7628 woven fiberglass cloth on a laboratory treater. The resulting prepreg was hot-pressed into 8-ply copper clad laminate on a hydraulic press at 600 psi under conditions as well be set forth in the tables that follow.

Run 210

The formulation of Run 209 plus A-1100 silane (14 g, 0.25 wt-% on solids basis).

Run 213-1

The formulation of Run 209 plus Additive 57 polysiloxane wetting agent (3 g, 0.05 wt-% on solids basis).

Run 213-2

The formulation of Run 213-1 plus A-1100 silane (14 g, 0.25 wt-% on solids basis).

Run 216-1

The formulation of Run 209 plus A-1100 silane (7 g, 0.125 wt-% on a solids basis).

Run 216-2

The formulation of Run 209 plus A-1100 silane (21 g, 0.375 wt-% on solids basis).

Run 236

The formulation of Run 209 plus A-1100 silane (0.5 wt-% on a solids basis), Additive 57 polysiloxane (0.05 wt-% on a solids basis), and Aerosil 200 fumed silica (0.75 wt-% on a solids basis).

Run C-5

The formulation 209 with EMI-24 (0.4 wt-% on a solids basis) replacing heptadecylimidazole.

Run 3-5

The formulation of Run C-5 plus A-1100 silane (0.5 wt-% on a solids basis).

Run 5-5

The formulation of Run C-5 plus A-1100 silane (1.0 wt-% on a solids basis).

The platen temperatures, cure times, and performance data recorded are set forth below in the

following four tables:

TABLE 3

| PPO/HYBRID EPOXY FORMULATIONS (16% of PPO EQUILIBRATED AT 6%) HEPTADECYLIMIDAZOLE CATALYST SOLDER FLOAT TESTS SECONDS TO BLISTER AT 550° F | | | | | | |
|---|---|---|---|---|---|---|
| | | Pressing Conditions | | | | |
| | | Platen Temp. (°C) Cure Time (minutes) | | | | |
| Run No. | Level of A-1100 (%) | 250/8 | 250/5 | 250/3 | 240/5 | 240/3 |
| 277-209 | 0 | 193 | 300+ | 217+ | (240-300)+ | 274+ |
| 277-210 | 0.25 | (280-300)+ | 300+ | (240-260)+ | --- | --- |
| 277-213-1 | 0 | --- | 197-237 | <280 | --- | --- |
| 277-213-2 | 0.25 | --- | 300+ | 300+ | --- | --- |
| 277-216-1 | 0.125 | --- | 218+ | 300+ | --- | --- |
| 277-216-2 | 0.375 | --- | 300+ | 300+ | --- | --- |
| 277-236 | 0.5 | --- | --- | --- | 300+ | 300+ |

TABLE 4

| PPO/HYBRID EPOXY FORMULATIONS (16% OF PPO EQUILIBRATED AT 6%) HEPTADECYLIMIDAZOLE CATALYST DYNAMIC MECHANICAL ANALYSIS (DMA) DATA | | | | |
|---|---|---|---|---|
| | | Pressing Conditions | Tg - DMA | |
| Run No. | Level of A-1100(wt-%) | Platen Temp. (°C)/Cure Time (mins. | E″ | Tan Delta |
| 277-209 | 0 | 250/8 | 138-157-193 | 164-198 |
| 277-210 | 0.25 | 250/8 | 139-159-193 | 166-199 |
| 277-213-1 | 0 | 250/5 | 139-160-192 | 146-166-198 |
| 277-213-2 | 0.25 | 250/5 | 150-196 | 203 |
| 277-216-1 | 0.125 | 250/5 | 137-164-203 | 143-168-209 |
| 277-216-2 | 0.375 | 250/5 | 140-164-198 | 204 |
| 277-209 | 0 | 250/3 | 134- -192 | 140-162-198 |
| 277-210 | 0.25 | 250/3 | 157-194 | 164-200 |
| 277-213-1 | 0 | 250/3 | 128- -183 | 137- -191 |
| 277-213-2 | 0.25 | 250/3 | 137- -198 | 159-204 |
| 277-216-1 | 0.125 | 250/3 | 137-156-201 | 138-160-207 |
| 277-216-2 | 0.375 | 250/3 | 163-198 | 175-205 |
| 277-209 | 0 | 240/5 | 150-196 | 158-202 |
| 277-210 | 0.25 | 240/5 | 142-157-197 | 161-202 |
| 277-236 | 0.5 | 240/5 | 160-205 | 163-212 |
| 277-209 | 0 | 240/3 | 141-193 | 147-199 |
| 277-210 | 0.25 | 240/3 | 148-190 | 152-196 |
| 277-236 | 0.5 | 240/3 | 151-196 | 155-203 |

TABLE 5

| PPO/HYBRID EPOXY FORMULATIONS (16% OF PPO EQUILIBRATED AT 6%) 2,4-EMI CATALYZED | | | | | | |
|---|---|---|---|---|---|---|
| | | Pressing Conditions | % MC Absorp. (5′ dip) | % Expansion | | |
| | | Platen temp (°C)/Cure Time (min) | | Solder Dip at 550°F | | Sec to blister at 550°F |
| Run No. | Level of A-1100(wt-%) | | | 30 sec. | 60 sec | |
| C-5 | 0.0 | 240/5 | 0.66 | 0.00 | 0.08 | 300+ |
| 3-5 | 0.5 | 240/5 | 0.58 | 0.08 | 0.08 | 300+ |
| 5-5 | 1.0 | 240/5 | 0.42 | 0.00 | 0.09 | 300+ |
| C-5 | 0.0 | 240/3 | 0.91 | 0.00 | 0.00 | 300+ |
| 3-5 | 0.5 | 240/3 | 0.67 | 0.00 | 0.00 | 300+ |
| 5-5 | 1.0 | 240/3 | 0.49 | 0.08 | 0.00 | 300+ |
| C-5 | 0.0 | 240/2.25 | 0.14 | 0.20 | 0.00 | 273 |
| 3-5 | 0.5 | 240/2.25 | 0.09 | 0.26 | 0.26 | 287 |
| 5-5 | 1.0 | 240/2.25 | 0.00 | 0.08 | 0.08 | 300+ |

TABLE 6

| PPO/HYBRID EPOXY FORMULATIONS (16% OF PPO EQUILIBRATED AT 6%) 2,4-EMI CATALYZED | | | | |
|---|---|---|---|---|
| | | Pressing Conditions | Tg - DMA | |
| Run No. | Level of A-1100(wt-%) | Platen Temp. (°C)/Cure Time (mins. | E″ | Tan Delta |
| C-5 | 0.0 | 240/5 | 164-202 | 172-208 |
| 3-5 | 0.5 | 240/5 | 168-203 | 172-208 |
| 5-5 | 1.0 | 240/5 | 167-201 | 174-206 |
| C-5 | 0.0 | 240/3 | 146- -197 | 156- -203 |
| 3-5 | 0.5 | 240/3 | 160-201 | 176-207 |
| 5-5 | 1.0 | 240/3 | 164-202 | 168-207 |
| C-5 | 0.0 | 240/2.25 | 152- -193 | 158- -200 |
| 3-5 | 0.5 | 240/2.25 | 162-203 | 174-209 |
| 5-5 | 1.0 | 240/2.25 | 153- -201 | 167-206 |

The results reported in Tables 3 and 4 illustrate the beneficial effect of the silane on cure speed of the heptadecylimidazole catalyzed version of the novel curable compositions of the present invention, particularly in the solder float test results tabulated at Table 3. The results tabulated in Tables 5 and 6 again show the beneficial effect of silanes on cure speed of the 2-ethyl-4-methylimidazole catalyzed versions of the novel curable compositions. Use levels for optimizing performance also can be ascertained from the results set forth at Tables 5 and 6.

EXAMPLE 3

In Run No. 285-1, PPO (99 g) was equilibrated with bisphenol-A (6 g) in 78% benzoyl peroxide (7.6 g) in the presence of DER 542 brominated epoxy (5487 g) at 95 °C for 90 minutes. Additional PPO (1888 g), toluene (2945 g), Component 270-75 (75% solids in toluene, 1430 g), EPN 1138 epoxy (681 g), and maleic anhydride (14 g) then were added and the mixture was maintained at 90 °-95 °C for an additional 30 minutes, following which heat was discontinued. The stirred mixture then was allowed to cool towards 60 °C as T-705 zinc octoate catalyst (300 g), Additive 57 polysiloxane (3 g), and Cabosil M-5 silica (42 g) were added. This mixture was stirred and held at 50 °-60 °C for 15 minutes, then applied to style 7628 woven fiberglass cloth on a laboratory treater.

The formulation of Run No. 285-2 was obtained by adding sufficient A-1100 silane (14 g) in 400 g of toluene to the circulating varnish mix in the treater dip tank to produce a level of 0.5 wt-% of silane based on the solids in the varnish.

The resulting prepregs were hot-pressed into 8-ply copper clad laminates on a hydraulic press at 600 psi using a platen temperature of 240 °C. The cure time and performance results recorded are set forth in Table 7 below.

TABLE 7

| PPO/HYBRID EPOXY FORMULATION (5% OF PPO EQUILIBRATED AT 6%) MALEIC ANHYDRIDE - 0.25% | | | | | |
|---|---|---|---|---|---|
| | | | Tg (°C) = DMA | | Solder Float Test-Seconds to blister at 550 °F |
| Run No. | Catalyst | Cure Time (Minutes) | E'' | Tan Delta | |
| 285-1 | MA-0.25% | 5 | 164-197 | 169-202 | 114 |
| 285-1 | MA-0.25% | 3 | 137-185 | 147-192 | 91 |
| 285-2 | MA-0.25% A-1100-0.5% | 5 | 162-200 | 167-206 | 300 + |
| 285-2 | MA-0.25% A-1100-0.5% | 3 | 161-197 | 165-202 | 300 + |

Another illustration of the curing ability of silanes is given by the data reported in Table 7. This system contains a smaller proportion of equilibrated PPO than the formulation in Example 2, and maleic anhydride instead of an imidazole catalyst. Adding the silane to the formulation markedly improved the solder blister times and 3 minute cure time DMA $T_g$s.

## Claims

1. A curable composition containing at least about 5% chemically combined bromine and comprising the following components:

(a) between about 25% and 50% by weight of (a), (b), (c) of at least one polyphenylene ether;

(b) between about 40% and 60% by weight of (a), (b), and (c) of a combination comprising:

(i) between about 35% and 45% by weight of a brominated upstaged polyepoxide composition comprising the reaction product of a halogen-free diglycidyl ether of a bisphenol and a bisphenol containing bromine as aryl substituents; and

(ii) between about 55% and 65% by weight of a polyepoxide composition comprising at least one bisphenol polyglycidyl ether having an average of at most one aliphatic hydroxyl group per molecule and containing between about 10% and 60% bromine as aryl substituents;

(c) up to about 25% of a halogen-free epoxidized novolak;

(d) a catalytically-effective amount of an epoxy resin catalyst; and

(e) an inert solvent.

2. The composition of claim 1 wherein (ii) comprises compounds having the formula:

(III) 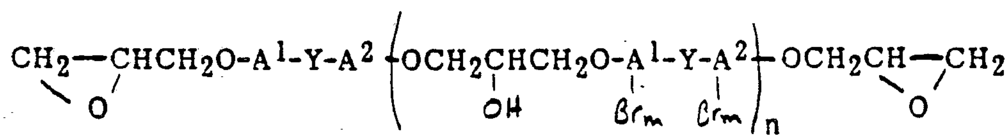

wherein m is 0-4 and n has an average value of up to 1.

3. The composition of claim 2 wherein n is 0 and said polyphenylene ether comprises poly(2,6-dimethyl-1,4-phenylene ether) having a number average molecular weight within the range of about 3,000-40,000.

4. The composition of claim 1 wherein said halogen-free diglycidyl ether of a bisphenol of (i) may be represented by the formula:

(II) 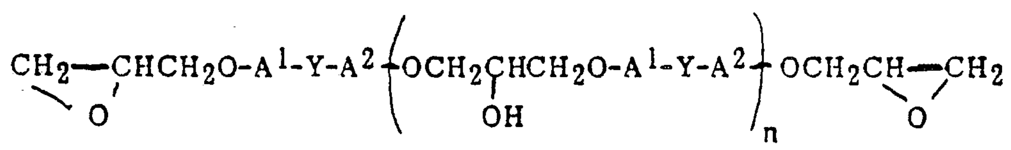

wherein n has an average value up to 1, each of $A^1$ and $A^2$ is a monocyclic divalent aromatic radical, and Y is a bridging radical in which one or two atoms separate $A^1$ from $A^2$.

5. The composition of claim 2 wherein halogen-free diglycidyl ether of a bisphenol of (i) is represented by the formula:

(II) 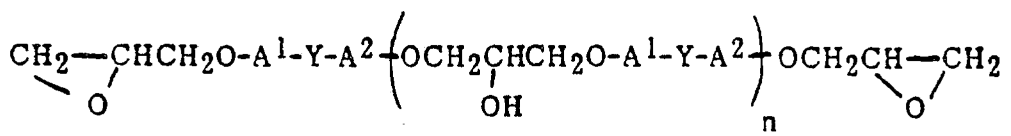

wherein n has an average value up to 1.

6. The composition of claim 1 wherein said bisphenol containing bromine as aryl substituents of component (i) comprises 2,2-bis(3,5-dibromo-4-hydroxyphenyl) propane.

7. The composition of claim 4 wherein said bisphenol containing bromine as aryl substituents of component (i) comprises 2,2-bis(3,5-dibromo-4-hydroxyphenyl) propane.

8. The composition of claim 1 wherein component (c) is made from formaldehyde, phenol, and epichlorohydrin.

9. The composition of claim 1 wherein said solvent comprises toluene.

10. The composition of claim 1 wherein said catalyst is selected from the group consisting of an imidazole, an arylene polyamine, a silane, and mixtures thereof.

11. The composition of claim 10 wherein said catalyst is selected from the group consisting of imidazole, 1-methylimidazole, 1,2-dimethylimidazole, 2-methylimidazole, 2-heptadecylimidazole, 2-ethyl-4-methylimidazole, 2-undecylimidazole, 1-2(-cyanoethyl)-2-phenylimidazole, diethyl toluene diamine, tris-(dimethylaminomethyl)phenol, 3-phenyl-1-dimethylurea, 3-(2-aminoethyl)-aminopropyl trimethoxysilane, gammaaminopropytriethoxysilane, glycidoxypropyltrimethoxysilane, and mixtures thereof.

12. The composition of claim 1 additionally comprising (f) a cocatalytically effective amount of one or more of zinc, magnesium, or aluminum in the form of a salt which is soluble or stably dispersible in said curable composition, maleic anhydride, and $BF_3$-ethylamine complex.

13. The composition of claim 12 wherein component (f) is selected from the group of zinc acetylacetonate, zinc stearate, zinc octoate, magnesium stearate, aluminum acetylacetonate, zinc neodecanate, zinc naphthenate, and mixtures thereof.

14. The composition of claim 1 which additionally comprises (g) at least one aliphatic tris(dialkylphosphato)-titanate of the formula:

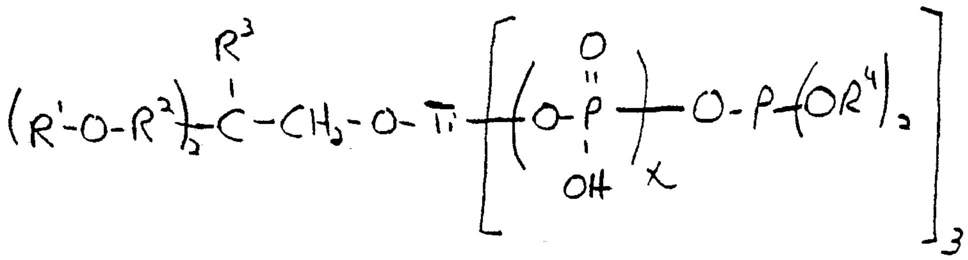

where $R^1$ is a $C_2$-$C_6$ primary or secondary alkyl or alkanyl group, $R^2$ is a $C_1$-$C_3$ alkanyl group, $R^3$ is a $C_1$-$C_5$ primary or secondary alkyl group, $R^4$ is a $C_5$-$C_{12}$ primary or secondary alkyl group, x is from 0 to about 3, said titanate being present in the amount of about 0.1-1.0 parts by weight per 100 parts of said composition.

15. The composition of claim 1 which additionally comprises (h) antimony pentoxide stably dispersed therein in an amount of up to 4 weight parts per 100 weight parts of said composition.

16. The composition of claim 1 wherein component (ii) is reacted with component (i) supplied to said curable composition.

17. The composition of claim 2 wherein (b) comprises the reaction product of a diglycidyl ether of bisphenol A, a halogenated polyglycidyl ether containing between about 10% and 60% bromine as aryl substituents, and tetrabromobisphenol A.

18. The composition of claim 1 wherein (a) is comprised of a plurality of structural units having the formula:

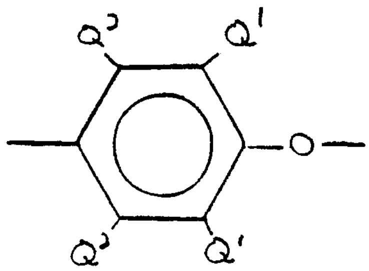

where,

each $Q^1$ independently is halogen, a primary or secondary lower alkyl, phenyl, haloalkyl, aminoalkyl, hydroxycarbonoxy, or halohydroxycarbonoxy wherein at least two carbon atoms separate the halogen and oxygen atoms; and each $Q^2$ independently is hydrogen, halogen, a primary or secondary lower alkyl, phenyl, haloalkyl, hydrocarbonoxy, or halohydroxycarbonoxy as defined for $Q^1$.

19. A curable composition containing at least about 5% chemically combined bromine and comprising the following components:

(a) between about 25% and 50% by weight of (a), (b), (c) of at least one polyphenylene ether;

(b) between about 40% and 60% by weight of (a), (b), and (c) of a combination comprising:

(i) between about 35% and 45% by weight of a brominated upstaged polyepoxide composition comprising the reaction product of a halogen-free diglycidyl ether of a bisphenol and a bisphenol containing bromine as aryl substituents; and

(ii) between about 55% and 65% by weight of a polyepoxide composition comprising at least one bisphenol polyglycidyl ether having an average of at most one aliphatic hydroxyl group per molecule and containing between about 10% and 60% bromine as aryl substituents;

(c) between about 0 and 25% of a halogen-free epoxidized novolak;

(d) a catalytically-effective amount of one or more of an imidazole, an arylene polyamine, or a silane;

(e) an inert solvent; and

(f) a cocatalytically effective amount of one or more of zinc, magnesium, or aluminum in the form of a salt which is soluble or stably dispersible in said curable composition, maleic anhydride, or a $BF_3$-ethylamine complex.

20. The composition of claim 19 wherein component (a) is a poly(2,6-dimethyl-1,4-phenylene ether) having a number average molecular weight within the range of about 3,000-40,000;

component (ii) has the formula:

(III) 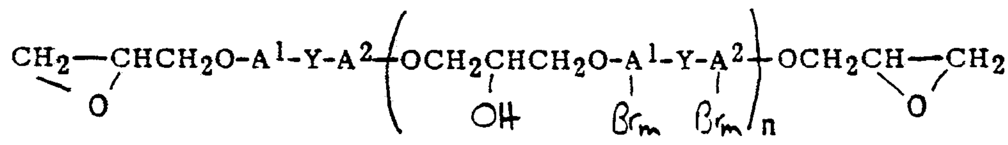

wherein m is 0-4 and n has an average value up to 1.

21. The composition of claim 19 wherein said halogen-free diglycidyl ether of a bisphenol of (i) may be represented by the formula:

(II) 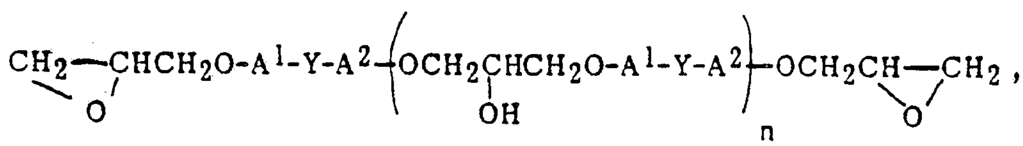

wherein n has an average value up to 1, each of $A^1$ and $A^2$ is a monocyclic divalent aromatic radical, and Y is a bridging radical in which one or two atoms separate $A^1$ from $A^2$.

22. The composition of claim 21 wherein halogen-free diglycidyl ether of a bisphenol of (i) is represented by the formula

(II) 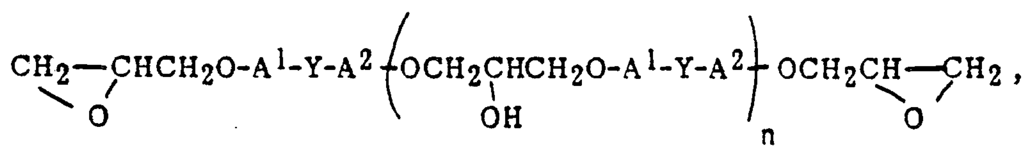

wherein n has an average value up to 1.

23. The composition of claim 19 wherein said bisphenol containing bromine as aryl substituents of component (i) comprises 2,2-bis(3,5-dibromo-4-hydroxyphenyl) propane.

24. The composition of claim 21 wherein said bisphenol containing bromine as aryl substituents of component (i) comprises 2,2-bis(3,5-dibromo-4-hydroxyphenyl) propane.

25. The composition of claim 19 wherein (b) comprises the reaction product of a diglycidyl ether of bisphenol A, a halogenated polyglycidyl ether containing between about 10% and 60% bromine as aryl substituents, and tetrabromobisphenol A.

26. The composition of claim 19 wherein (a) is comprised of a plurality of structural units having the formula:

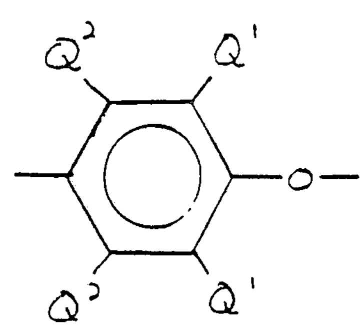

where,

each $Q^1$ independently is halogen, a primary or secondary lower alkyl, phenyl, haloalkyl, aminoalkyl, hydroxycarbonoxy, or halohydroxycarbonoxy wherein at least two carbon atoms separate the halogen and oxygen atoms; and each $Q^2$ independently is hydrogen, halogen, a primary or secondary lower alkyl, phenyl, haloalkyl, hydrocarbonoxy, or halohydroxycarbonoxy as defined for $Q^1$.

27. The composition of claim 19 wherein said catalyst is selected from the group consisting of imidazole, 1-methylimidazole, 1,2-dimethylimidazole, 2-methylimidazole, 2-heptadecylimidazole, 2-ethyl-4-methylimidazole, 2-undecylimidazole, 1-2(-cyanoethyl)-2-phenylimidazole, diethyl toluene diamine, tris-(dimethylaminomethyl)phenol, 3-phenyl-1-dimethylurea, 3-(2-aminoethyl)-aminopropyl trimethoxysilane, gammaaminopropytriethoxysilane, glycidoxypropyltrimethoxysilane, and mixtures thereof.

28. An article comprising a fibrous substrate impregnated with the curable composition of claim 1.

29. An article comprising a fibrous substrate impregnated with the curable composition of claim 3.

30. An article comprising a fibrous substrate impregnated with the curable composition of claim 7.

31. An article comprising a fibrous substrate impregnated with the curable composition of claim 10.

32. An article comprising a fibrous substrate impregnated with the curable composition of claim 19.

33. An article comprising a fibrous substrate impregnated with the curable composition of claim 22.

34. An article comprising a fibrous substrate impregnated with the curable composition of claim 24.

35. A laminate comprising the article according to claim 28 clad with a conductive metal.

36. The laminate of claim 35 wherein said conductive metal comprises copper.

37. A laminate comprising the article according to claim 29 clad with a conductive metal.

38. The laminate of claim 37 wherein said metal comprises copper.

39. A laminate comprising the article according to claim 30 clad with a conductive metal.

40. The laminate of claim 39 wherein said conductive metal comprises copper.

41. A laminate comprising the article according to claim 31 clad with a conductive metal.

42. The laminate of claim 41 wherein said conductive metal comprises copper.

43. A laminate comprising the article according to claim 32 clad with a conductive metal.

44. The laminate of claim 43 wherein said metal comprises copper.

45. A laminate comprising the article according to claim 33 clad with a conductive metal.

46. The laminate of claim 45 wherein said conductive metal comprises copper.

47. A laminate comprising the article according to claim 34 clad with a conductive metal.

48. The laminate of claim 47 wherein said metal comprises copper.

European Patent Office

# EUROPEAN SEARCH REPORT

Application Number

**EP 90 11 8852**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X,P | EP-A-0 383 178 (GENERAL ELECTRIC COMPANY)<br>* claims *<br>– – – | 1-48 | C 08<br>L 63/00<br>C 08 L 71/12<br>B 32 B 15/08<br>B 32 B 27/04<br>H 05 K 1/03 |
| X,D | US-A-4 853 423 (E. K. WALLES ET AL.)<br>* claims 1, 3, 11, 13 *<br>– – – | 1-48 | |
| A | US-A-3 888 942 (L. K. TSENG)<br>* claims 1, 5, 6 *<br>– – – | 1 | |
| A | Database WPIL, no. 81-76811 Derwent Publications Ltd, London, GB,<br>& JP-A-56112924 (Matsushita Elec Works) 05-09-81 see the whole abstract<br>– – – – – | 1 | |
| | | | **TECHNICAL FIELDS SEARCHED (Int. Cl.5)** |
| | | | C 08 L |

The present search report has been drawn up for all claims

| Place of search | Date of completion of search | Examiner |
|---|---|---|
| The Hague | 25 January 91 | PRAS J-L.C.N. |

CATEGORY OF CITED DOCUMENTS

X: particularly relevant if taken alone
Y: particularly relevant if combined with another document of the same catagory
A: technological background
O: non-written disclosure
P: intermediate document
T: theory or principle underlying the invention

E: earlier patent document, but published on, or after the filing date
D: document cited in the application
L: document cited for other reasons

&: member of the same patent family, corresponding document